# FASCICULE DE BREVET EUROPEEN

(11) **EP 2 341 564 B1**
(45) Date de publication et mention de la délivrance du brevet: **30.09.2015**
(21) Numéro de dépôt: 10306180.0
(22) Date de dépôt: 27.10.2010
(51) Int. Cl.: H01L 41/04, D06F 75/10, F04B 43/04, F04B 49/02, A45D 6/00, D06F 75/26

(54) **Procédé de pilotage d'une pompe piézoélectrique d'appareil électroménager et appareil électroménager mettant en oeuvre un tel procédé**
Verfahren zur Steuerung einer piezoelektrischen Pumpe in einem elektrischen Haushaltsgerät und elektrisches Haushaltsgerät mit einem derartigen Steuerungsverfahren
Method of driving a piezoelectric pump of an electric domestic appliance and electric domestic appliance employing such method

(30) Priorité: 04.11.2009 FR 0905286
(43) Date de publication de la demande: 06.07.2011
(73) Titulaire: SEB S.A., 69130 Ecully (FR)
(72) Inventeur: Couet, Betrand, 69700 Loire-sur-Rhône (FR); Mandica, Franck, 69340 Francheville (FR); Cubizolles, Serge, 38780 Oytier Saint Oblas (FR); Lavillat, Oliver, 74600 Quintal (FR)
(74) Mandataire: Bourrières, Patrice

(56) Documents cités:
- EP-A1- 0 789 146
- WO-A1-2006/100627
- WO-A1-2009/083417
- WO-A1-2009/130407

## Description

La présente invention se rapporte à un procédé de pilotage d'une pompe piézoélectrique d'appareil électroménager comportant une chambre de pompage munie d'une paroi mobile se déplaçant sous l'action d'un actionneur piézoélectrique et à un appareil électroménager comportant une pompe piézoélectrique alimentée électriquement par un circuit mettant en oeuvre un tel procédé de pilotage.

Le document EP 789 146 divulgue une micro-pompe pour la distribution d'un produit chimique comportant une chambre de pompage munie d'une paroi mobile se déplaçant sous l'action d'un élément piézoélectrique. L'élément piézoélectrique est alimenté par un signal de commande comprenant un nombre d'impulsions prédéterminé sur une période de temps donnée, le signal pouvant comprendre des périodes durant lesquelles aucune impulsion n'est réalisée.

La demande de brevet FR 2 929 450 déposée par la demanderesse, divulgue un appareil électroménager comportant une pompe piézoélectrique alimentée à partir du réseau électrique domestique, la pompe comprenant une chambre de pompage munie d'une paroi mobile se déplaçant sous l'action de l'actionneur piézoélectrique, l'actionneur étant alimenté par un circuit d'alimentation générant un signal d'alimentation alternatif provoquant un déplacement périodique de la paroi mobile. Un tel circuit d'alimentation présente l'avantage d'être fiable et économique à mettre en oeuvre. Cependant, un tel circuit d'alimentation présente l'inconvénient de ne pas permettre la modulation du débit de la pompe et notamment la réduction du débit.

Il est connu de réduire le débit de la pompe en agissant sur la tension aux bornes de l'actionneur piézoélectrique, une réduction de la tension permettant d'obtenir une moindre déformation de l'actionneur piézoélectrique et donc une réduction du volume balayé par la paroi mobile lors d'une alternance du signal électrique. Cependant, la réduction de la tension présente l'inconvénient de réduire le taux de compression de la pompe, c'est-à-dire le rapport entre le volume balayé par la paroi mobile et le volume mort de la chambre de pompage. Or, une baisse du taux de compression de la pompe en deçà d'un seuil prédéterminé provoque des problèmes d'auto-amorçage de la pompe et/ou d'évacuation des bulles d'air présentes dans la chambre de pompage.

Il est également connu de réduire le débit d'une pompe piézoélectrique en abaissant la fréquence du signal électrique aux bornes de l'actionneur piézoélectrique de manière à ce que le volume balayé par la paroi mobile dans un temps donné soit moins important. Une telle solution présente cependant l'inconvénient de nécessiter un circuit de modulation de la fréquence relativement couteux à fabriquer. De plus, l'abaissement de la fréquence du signal d'alimentation présente également l'inconvénient de réduire la vitesse de déplacement de la paroi mobile qui n'est alors plus suffisante pour permettre une bonne évacuation des éventuelles bulles d'air présentes dans la chambre de pompage.

Aussi, un but de la présente invention est de remédier à ces inconvénients en proposant un procédé de pilotage permettant de faire fonctionner une pompe piézoélectrique d'appareil électroménager à débit réduit par rapport au débit normalement fourni par la pompe sans rencontrer de problème d'auto-amorçage et d'évacuation de bulles d'air.

A cet effet, l'invention a pour objet un procédé de pilotage d'une pompe piézoélectrique d'appareil électroménager comprenant une chambre de pompage munie d'une paroi mobile se déplaçant sous l'action d'un actionneur piézoélectrique, caractérisé en ce que, durant une phase de démarrage de la pompe, l'actionneur piézoélectrique est alimenté sur plusieurs alternances avec un signal d'alimentation alternatif présentant une tension U générant une forte déformation de l'actionneur piézoélectrique pour un balayage maximum du volume de la chambre de pompage par la paroi mobile, et en ce que la phase de démarrage de la pompe est suivie d'une phase de fonctionnement normal durant laquelle la tension U du signal d'alimentation est abaissée par rapport à la tension U du signal d'alimentation utilisée durant la phase de démarrage et/ou la fréquence du signal d'alimentation est plus faible que durant la phase de démarrage, pour que le débit moyen fourni par la pompe soit inférieur au débit fourni pendant la phase de démarrage.

Selon encore une autre caractéristique de l'invention, la phase de démarrage correspond à un temps de fonctionnement t₀ prédéterminé.

L'invention concerne également un appareil électroménager comportant une pompe piézoélectrique alimentée à partir du réseau électrique domestique, la pompe piézoélectrique comprenant une chambre de pompage munie d'une paroi mobile se déplaçant sous l'action d'un actionneur piézoélectrique, l'actionneur étant alimenté par un circuit d'alimentation générant un signal d'alimentation alternatif provoquant un déplacement périodique de la paroi mobile, caractérisé en ce que le circuit d'alimentation de la pompe met en oeuvre le procédé de pilotage précédemment décrit.

Selon une autre caractéristique de l'invention, le circuit d'alimentation comporte des moyens pour réduire l'amplitude de la tension du signal d'alimentation après une phase de démarrage de la pompe.

Selon une autre caractéristique de l'invention, le circuit d'alimentation de la pompe comporte un dispositif pour hacher le signal d'alimentation de manière à ce que la tension d'alimentation ne soit appliquée que sur certaines alternances.

Selon une autre caractéristique de l'invention, le signal d'alimentation est asymétrique.

Selon encore une autre caractéristique de l'invention, le signal d'alimentation possède uniquement des alternances positives.

Selon une autre caractéristique de l'invention, l'appareil électroménager est un appareil de repassage, tel un fer à repasser ou un défroisseur.

Selon une variante de l'invention, l'appareil électroménager est un appareil de coiffure, tel un lisseur.

On comprendra mieux les buts, aspects et avantages de la présente invention, d'après la description donnée ci-après d'un exemple de réalisation de l'invention présenté à titre d'exemple non limitatif, en se référant aux dessins annexés dans lesquels :
- la figure 1 est une vue en perspective d'un fer à repasser mettant en oeuvre le procédé de pilotage selon l'invention ;
- la figure 2 est une vue en perspective partiellement éclatée du fer à repasser de la figure 1 ;
- la figure 3 est une vue en perspective éclatée de la pompe équipant le fer des figures 1 et 2 ;
- la figure 4 est une vue en coupe de la pompe de la figure 3 ;
- la figure 5 est une présentation schématique du circuit d'alimentation de la pompe de la figure 4 ;
- les figures 6A, 6B et 6C représentent le signal d'alimentation de la pompe suivant différentes variantes de réalisation du procédé de pilotage.

Seuls les éléments nécessaires à la compréhension de l'invention ont été représentés. Pour faciliter la lecture des dessins, les mêmes éléments portent les mêmes références d'une figure à l'autre.

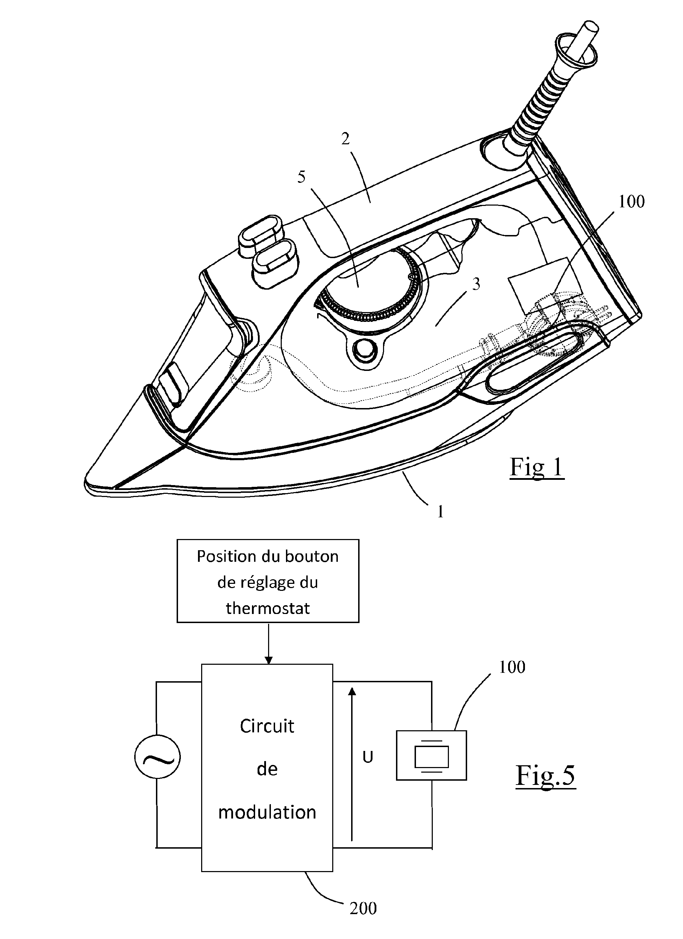

La figure 1 représente un fer à repasser comportant une semelle 1 de repassage surmontée d'un corps comprenant une poignée 2 et un bouton de commande 5 d'un thermostat de régulation de la température de la semelle 1, le corps renfermant un réservoir 3 d'eau et une pompe 100 piézoélectrique dont le fonctionnement est contrôlé au moyen d'une gâchette de commande disposée sous la poignée 2, non visible sur les figures.

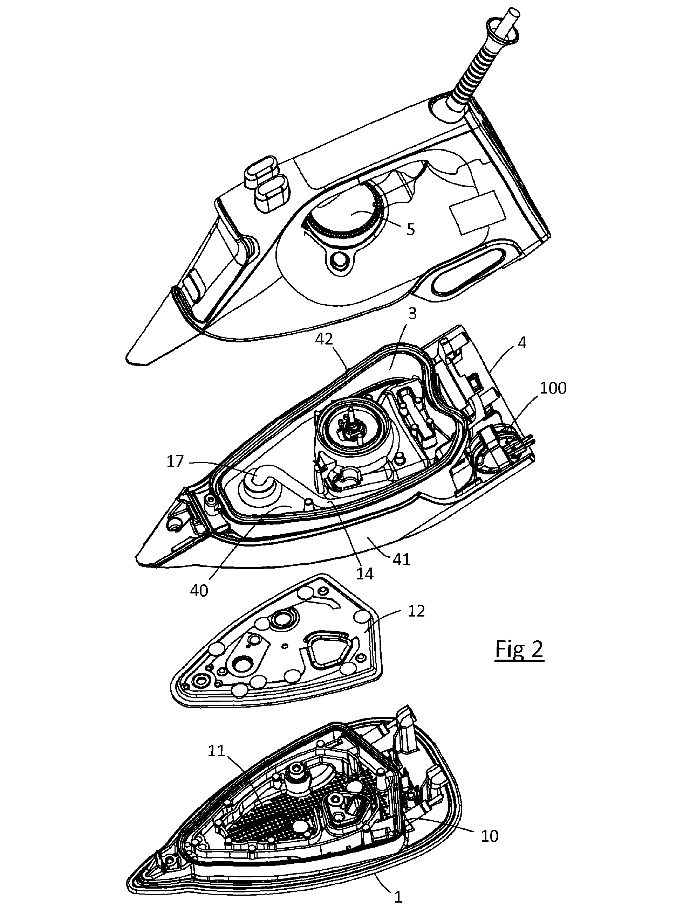

Conformément à la figure 2, illustrant le fer en vue éclatée, la semelle 1 du fer est en contact thermique avec un corps chauffant 10 qui intègre, de manière connue en soi, une chambre de vaporisation 11 pour la production de vapeur, la chambre de vaporisation 11 étant fermée par un couvercle 12 et étant reliée à un circuit de distribution de vapeur comprenant des trous de sortie de vapeur ménagés dans la semelle 1.

Afin de limiter la diffusion de chaleur vers la poignée 2 du fer, le corps chauffant 10 est surmonté d'un écran thermique 4 comportant une partie centrale 40 définissant le fond du réservoir 3 et une partie périphérique constituant une jupe de protection 41 s'étendant sous le fond du réservoir 3 en épousant le contour de la semelle 1 de manière à venir border latéralement le corps chauffant 10.

L'écran thermique 4 supporte également la pompe 100 piézoélectrique, cette dernière étant disposée à l'extérieur du réservoir 3 et étant reliée à un tube d'aspiration débouchant dans le fond du réservoir, visible sur la figure 1, et à un tube de refoulement débouchant au travers d'une ouverture du couvercle située au dessus de la chambre de vaporisation 11.

De cette manière, l'eau aspirée dans le réservoir 3 par la pompe 100 est envoyée directement dans la chambre de vaporisation 11, la vapeur ainsi produite présentant un débit directement proportionnel au débit de la pompe.

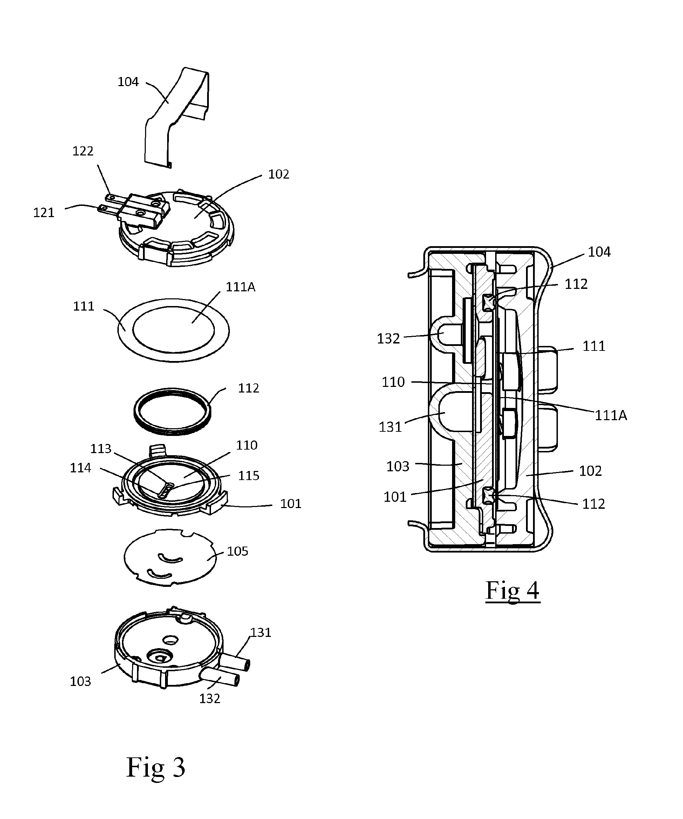

Conformément aux figures 3 et 4, la pompe 100 piézoélectrique, décrite plus en détails dans la demande de brevet FR 08 06960, comporte une chambre de pompage 110 délimitée latéralement par un joint d'étanchéité 112 disposé entre un support 101 en polyamide et une paroi mobile 111. La paroi mobile 111 est constituée par une membrane en laiton comportant une face externe, orientée vers l'extérieur de la chambre de pompage 110, sur laquelle est fixé un actionneur piézoélectrique 111A en céramique. La paroi mobile 111 est maintenue contre le joint d'étanchéité 112 au moyen d'une agrafe élastique 104 venant s'engager sur un couvercle 102 et une embase 103 disposés de part et d'autre du support 101.

L'embase 103 comporte un conduit d'aspiration 131 débouchant dans la chambre de pompage 110 au niveau d'un orifice d'entrée 113 disposé au centre de la chambre de pompage 110 de manière à se trouver en regard de la zone de débattement maximum de la paroi mobile 111, où la dépression est la plus importante.

L'embase comporte également un conduit de refoulement 132 débouchant dans la chambre de pompage 110 au niveau d'un orifice de sortie 114 disposé à proximité de la périphérie de la chambre de pompage 110, la pompe 100 étant placée verticalement dans le fer de telle sorte que l'orifice de sortie 114 se trouve au sommet de la chambre de pompage 110 lorsque le fer repose à plat sur sa semelle 1. Un film 105 en silicone est interposé entre le support 101 et l'embase 103 pour réaliser des clapets en regard de l'orifice d'entrée 113 et de l'orifice de sortie 114.

Afin de faciliter l'évacuation d'éventuelles bulles d'air présentes dans la chambre de pompage, la chambre de pompage 101 comporte une rainure 115, d'une profondeur de l'ordre de 1 mm, s'étendant entre les orifices d'entrée 113 et de sortie 114 sur la face du support 101 en regard du couvercle 102, cette rainure 115 permettant de canaliser les bulles d'air en direction de l'orifice de sortie.

Le couvercle 102 de la pompe comporte des bornes d'alimentation 121, 122 reliées électriquement à la paroi mobile 111 et à l'actionneur piézoélectrique 111A, ces bornes 121, 122 étant alimentées par une tension électrique alternative provoquant une déformation périodique de l'actionneur piézoélectrique 111A et de la paroi mobile 111 souple dans le sens de l'augmentation puis de la réduction du volume de la chambre de pompage 110.

Conformément à la figure 5, le fer à repasser comporte un circuit d'alimentation de la pompe piézoélectrique 100 comprenant un circuit de modulation 200 permettant de modifier le signal alternatif fourni par le réseau électrique domestique. Ce circuit de modulation 200 reçoit avantageusement une information sur la position du bouton de commande 5 du thermostat de manière à ce que le débit de la pompe 100 soit régulé en fonction de la température de consigne de la semelle 1. A titre d'exemple, la pompe 100 sera régulée pour fournir un débit de vapeur de l'ordre de 40 g/mn lorsque le thermostat est réglé pour obtenir une température de la semelle de l'ordre de 200°C et pour fournir un débit de vapeur de 10 g/mn lorsque le thermostat est réglé pour obtenir une température de la semelle de l'ordre de 110°C.

Plus particulièrement selon l'invention, le circuit d'alimentation de la pompe piézoélectrique 100 fourni, indépendamment du débit souhaité, un signal d'alimentation présentant, durant une phase de démarrage de la pompe, une tension alternative suffisamment élevée pour générer un balayage maximum du volume de la chambre de pompage 110 par la paroi mobile 111. Ce signal d'alimentation est ensuite modifié dans une phase de fonctionnement normal, successive à la phase de démarrage de la pompe, de manière à faire correspondre le débit de la pompe au débit souhaité.

Le passage de la phase de démarrage à la phase de fonctionnement normal s'effectuant préférentiellement après le décompte, par un microcontrôleur, d'un temps de fonctionnement t₀ prédéterminé correspondant à plusieurs alternances du signal d'alimentation de la pompe 100. A titre d'exemple le délai t₀ pourra être de l'ordre de 100 ms pour un signal d'alimentation alternatif présentant une fréquence de l'ordre de 50 Hz.

De cette manière, on obtient, lors du démarrage de la pompe, un fort balayage de la chambre de pompage 110 par la paroi mobile 111 de sorte que le volume mort dans la chambre de pompage 110 est réduit essentiellement à la rainure 115. L'eau circulant dans la pompe 110 durant la phase de démarrage circule donc principalement dans la rainure 115 reliant l'orifice d'entrée 113 et l'orifice de sortie 114, ce qui permet d'obtenir une vitesse de circulation très élevée favorisant l'arrachement des bulles et l'amorçage de la pompe 100.

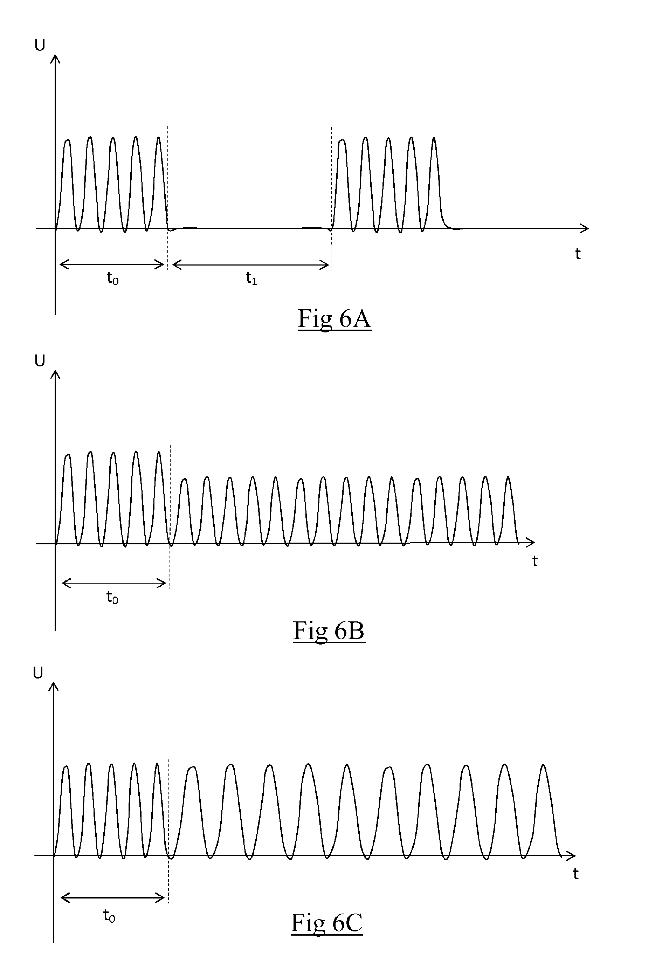

A titre d'exemple, et ainsi cela est illustré sur la figure 6A, l'actionneur piézoélectrique 111A est alimenté durant la phase de démarrage avec une tension U alternative présentant une fréquence de 50 Hz et une amplitude de l'ordre de 230V. Cette tension est préférentiellement asymétrique pour limiter les phénomènes de dépolarisation de l'actionneur piézoélectrique.

Après un délai t₀ de 100 ms, le signal d'alimentation est haché périodiquement par le circuit d'alimentation de manière à stopper momentanément l'activation de la paroi mobile 111 pour réduire le débit moyen de la pompe 100. Dans l'exemple illustré, le signal d'alimentation est haché: il est interrompu sur une période t₁ de 140 ms puis est de nouveau semblable à celui de la phase de démarrage sur une période de 100 ms. On obtient ainsi une réduction du débit de l'ordre de t₁/(t₁+t₀) soit environ 60% par un fonctionnement intermittent de la pompe 100. Bien entendu le temps pendant lequel le signal est haché dépendra du débit souhaité, le débit moyen étant d'autant plus faible que le délai t₁ est important.

Dans la réalisation de l'invention représentée à la figure 6B, la pompe piézoélectrique 100 est alimentée pendant une phase de démarrage t₀ avec un signal d'alimentation semblable à celui décrit dans l'exemple de réalisation précédent, puis est alimenté avec un signal dont la tension U est réduite de manière à ce que la déformation de l'actionneur piézoélectrique 111A sur une alternance du signal soit moins importante afin que le volume balayé par la paroi mobile 111 soit réduit. On obtient ainsi un fonctionnement de la pompe à débit réduit après un délai t₀ de 100 ms, la conservation d'un signal provoquant un balayage maximum du volume de la chambre de pompage durant la phase de démarrage permettant d'assurer un bon autoamorçage de la pompe ainsi que l'évacuation des éventuelles bulles d'air. Un tel mode de réalisation présente l'avantage d'être simple et économique à mettre en oeuvre, la baisse de la tension U d'alimentation par le circuit d'alimentation pouvant s'effectuer à l'aide de composants peu couteux.

Dans une variante de réalisation illustrée sur la figure 6C, la pompe piézoélectrique 100 est toujours alimentée pendant une phase de démarrage t₀ avec un signal d'alimentation semblable à celui décrit dans le premier exemple de réalisation, puis le débit de la pompe est réduit en réduisant la fréquence du signal d'alimentation de la pompe. Une telle variante de réalisation présente cependant l'inconvénient d'être plus couteuse à mettre en oeuvre.

Le procédé de pilotage de la pompe ainsi décrit permet donc d'obtenir un fonctionnement sûr et efficace de la pompe à bas débit en optimisant dans un premier temps, pendant quelques millisecondes au démarrage de la pompe, le signal d'alimentation de la pompe pour optimiser les conditions d'autoamorçage et d'élimination des éventuelles bulles d'air, puis en modifiant dans un second temps le signal d'alimentation de la pompe pour diminuer le débit de la pompe de manière à tendre vers le débit souhaité, cette réduction du débit s'effectuant alors que la pompe est déjà amorcée et que les éventuelles bulles d'air, qui pourraient devenir gênantes dans le cas d'un fonctionnement avec moins de sollicitations de la paroi mobile, sont évacuées.

Le fer à repasser ainsi réalisé permet donc une régulation du débit de la pompe pour l'adapter aux conditions de repassage, cette modification du débit de la pompe pouvant s'effectuer soit de manière automatique en fonction de la température de réglage de la semelle, soit de manière manuelle en disposant sur le fer un bouton de réglage de la quantité de vapeur désirée.

Bien entendu, l'invention n'est nullement limitée au mode de réalisation décrit et illustré qui n'a été donné qu'à titre d'exemple. Des modifications restent possibles, notamment du point de vue de la constitution des divers éléments ou par substitution d'équivalents techniques, sans sortir pour autant du domaine de protection de l'invention.

Ainsi dans une variante de réalisation de l'invention, la forme de la chambre de pompage ou les moyens d'assemblage des éléments de la pompe pourront être modifiés.

## Revendications

1. Procédé de pilotage d'une pompe piézoélectrique (100) d'appareil électroménager comprenant une chambre de pompage (110) munie d'une paroi mobile (111) se déplaçant sous l'action d'un actionneur piézoélectrique (111A), **caractérisé en ce que**, durant une phase de démarrage de la pompe (100), l'actionneur piézoélectrique (111A) est alimenté sur plusieurs alternances avec un signal d'alimentation alternatif présentant une tension U générant une forte déformation de l'actionneur piézoélectrique (111A) pour un balayage maximum du volume de la chambre de pompage (110) par la paroi mobile (111), et **en ce que** la phase de démarrage de la pompe est suivie d'une phase de fonctionnement normal durant laquelle la tension U du signal d'alimentation est abaissée par rapport à la tension U du signal d'alimentation utilisée durant la phase de démarrage et/ou la fréquence du signal d'alimentation est plus faible que durant la phase de démarrage, pour que le débit moyen fourni par la pompe (100) soit inférieur au débit fourni pendant la phase de démarrage.

2. Procédé de pilotage d'une pompe piézoélectrique (100) selon la revendication 1, **caractérisé en ce que** la phase de démarrage correspond à un temps de fonctionnement t₀ prédéterminé.

3. Appareil électroménager comportant une pompe piézoélectrique (100) alimentée à partir du réseau électrique domestique, la pompe piézoélectrique (100) comprenant une chambre de pompage (110) munie d'une paroi mobile (111) se déplaçant sous l'action d'un actionneur piézoélectrique (111A), ledit actionneur (111A) étant alimenté par un circuit d'alimentation générant un signal d'alimentation alternatif provoquant un déplacement périodique de la paroi mobile (111), **caractérisé en ce que** ledit circuit d'alimentation de la pompe met en oeuvre le procédé de pilotage selon l'une quelconque des revendications 1 à 2.

4. Appareil électroménager selon la revendication 3, **caractérisé en ce que** le circuit d'alimentation comporte des moyens pour réduire l'amplitude de la tension du signal d'alimentation après une phase de démarrage de la pompe (100).

5. Appareil électroménager selon l'une quelconque des revendications 3 à 4, **caractérisé en ce que** le circuit d'alimentation de la pompe (100) comporte un dispositif pour hacher le signal d'alimentation de manière à ce que la tension d'alimentation ne soit appliquée que sur certaines alternances.

6. Appareil électroménager selon l'une quelconque des revendications 3 à 5, **caractérisé en ce que** le signal d'alimentation est asymétrique.

7. Appareil électroménager selon la revendication 6, **caractérisé en ce que** le signal d'alimentation possède uniquement des alternances positives.

8. Appareil électroménager selon l'une quelconque des revendications 3 à 7, **caractérisé en ce que** ledit appareil électroménager est un appareil de repassage, tel un fer à repasser ou un défroisseur.

9. Appareil électroménager selon l'une quelconque des revendications 3 à 7, **caractérisé en ce que** ledit appareil électroménager est un appareil de coiffure, tel un lisseur.

## Patentansprüche

1. Verfahren zur Ansteuerung einer piezoelektrischen Pumpe (100) eines Elektrohaushaltsgeräts mit einer Pumpkammer (110), die mit einer beweglichen Wand (111) ausgestattet ist, die sich unter der Einwirkung eines piezoelektrischen Betätigungselements (111 A) bewegt, **dadurch gekennzeichnet, dass** dem piezoelektrischen Betätigungselement (111 A) während einer Anlaufphase der Pumpe (100) auf mehreren Halbschwingungen ein Wechselstrom-Versorgungssignal mit einer Spannung U zugeführt wird, die eine starke Verformung des piezoelektrischen Betätigungselements (111 A) bei maximaler Abtastung des Volumens der Pumpkammer (110) durch die bewegliche Wand (111) bewirkt, und dass auf die Anlaufphase der Pumpe eine Phase normalen Betriebs folgt, während der die Spannung U des Versorgungssignals im Vergleich zur Spannung U des während der Anlaufphase verwendeten Versorgungssignals reduziert wird und/oder die Frequenz des Versorgungssignals niedriger ist als während der Anlaufphase, damit die von der Pumpe (100) bereitgestellte mittlere Fördermenge geringer als die während der Anlaufphase bereitgestellte Fördermenge ist.

2. Verfahren zur Ansteuerung einer piezoelektrischen Pumpe (100) nach Anspruch 1, **dadurch gekennzeichnet, dass** die Anlaufphase einer vorbestimmten Betriebsdauer t₀ entspricht.

3. Elektrohaushaltsgerät mit einer piezoelektrischen Pumpe (100), die von einem Haushaltsstromnetz versorgt wird, wobei die piezoelektrische Pumpe (100) eine Pumpkammer (110) umfasst, die mit einer beweglichen Wand (111) ausgestattet ist, die sich unter der Einwirkung eines piezoelektrischen Betätigungselements (111 A) bewegt, wobei das genannte Betätigungselement (111 A) von einem Versorgungskreis versorgt wird, der ein Wechselstrom-Versorgungssignal erzeugt, das eine periodische Bewegung der beweglichen Wand (111) bewirkt, **dadurch gekennzeichnet, dass** der genannte Versorgungskreis der Pumpe das Verfahren zur Ansteuerung nach einem der Ansprüche 1 bis 2 einsetzt.

4. Elektrohaushaltsgerät nach Anspruch 3, **dadurch gekennzeichnet, dass** der Versorgungskreis Mittel zur Verringerung der Amplitude der Spannung des Versorgungssignals nach einer Anlaufphase der Pumpe (100) umfasst.

5. Elektrohaushaltsgerät nach einem der Ansprüche 3 bis 4, **dadurch gekennzeichnet, dass** der Versorgungskreis der Pumpe (100) eine Vorrichtung zum Zerhacken des Versorgungssignals derart umfasst, dass die Versorgungsspannung nur bei bestimmten Halbschwingungen anliegt.

6. Elektrohaushaltsgerät nach einem der Ansprüche 3 bis 5, **dadurch gekennzeichnet, dass** das Versorgungssignal asymmetrisch ist.

7. Elektrohaushaltsgerät nach Anspruch 6, **dadurch gekennzeichnet, dass** das Versorgungssignal nur positive Halbschwingungen aufweist.

8. Elektrohaushaltsgerät nach einem der Ansprüche 3 bis 7, **dadurch gekennzeichnet, dass** das genannte Elektrohaushaltsgerät ein Bügelgerät, wie ein Bügeleisen oder ein Dampfglätter, ist.

9. Elektrohaushaltsgerät nach einem der Ansprüche 3 bis 7, **dadurch gekennzeichnet, dass** das genannte Elektrohaushaltsgerät ein Frisiergerät, wie ein Glätteisen, ist.

## Claims

1. Process for a piezoelectric pump (100) domestic appliance consisting of a pumping chamber (110) equipped with a movable wall (111) which is moved under the effect of a piezoelectric actuator (111 A), **characterised in that**, during the pump starting phase (100), the piezoelectric actuator (111 A) is supplied in several alternations with an alternative power signal which has a U voltage, which generates a strong deformation of the piezoelectric actuator (111 A) for maximum sweeping of the volume of the pumping chamber (110) by the movable wall (111), and also **in that** the pump starting phase is followed by a normal functioning phase during which the U voltage of the power signal is lowered in relation to the U voltage of the power signal used during the start phase, and/or the frequency of the power signal is weaker than during the starting phase, so that the average output supplied by the pump (100) is less than the output supplied during the start phase.

2. Process for a piezoelectric pump (100) according to claim 1, **characterised in that** the start phase corresponds to a predetermined functioning time t₀.

3. A domestic appliance consisting of a piezoelectric pump (100) supplied from the domestic electronic network, whereby the piezoelectric pump (100) consists of a pumping chamber (110) equipped with a movable wall (111) which is moved under the effect of a piezoelectric actuator (111 A), the aforementioned actuator (111 A) is supplied by a power supply which generates an alternative power signal which causes a periodic movement of the movable wall (111), **characterised in that** the aforementioned power supply of the pump starts the process according to either one of claims 1 to 2.

4. A domestic appliance according to claim 3, **characterised in that** the power supply has the means to reduce the amplitude of the power signal voltage after the pump starting phase (100).

5. A domestic appliance according to any one of claims 3 to 4, **characterised in that** the power supply of the pump (100) has a device to cut the power signal in such a way that the voltage supply is only applied to certain alternations.

6. A domestic appliance according to any one of claims 3 to 5, **characterised by** an asymmetric power signal.

7. A domestic appliance according to claim 6, **characterised in that** the power supply has only positive alternations.

8. A domestic appliance according to one of the claims from 3 to 7 **characterised in that** the aforementioned household appliance is an ironing appliance, such as an iron or a steam brush.

9. A domestic appliance according to any one of claims 3 to 7, **characterised in that** the aforementioned appliance is a hair care appliance, such as a hair straightener.
